Europäisches Patentamt

European Patent Office

Office européen des brevets

(11) Veröffentlichungsnummer: **0 495 470 A2**

# EUROPÄISCHE PATENTANMELDUNG

(21) Anmeldenummer: **92100541.9**

(51) Int. Cl.⁵: **H04B 15/02**

(22) Anmeldetag: **15.01.92**

(30) Priorität: **17.01.91 DE 4101256**

(43) Veröffentlichungstag der Anmeldung:
**22.07.92 Patentblatt 92/30**

(84) Benannte Vertragsstaaten:
**DE FR GB IT**

(71) Anmelder: **Firma Carl Zeiss**

**W-7920 Heidenheim (Brenz)(DE)**

(84) **DE FR IT**

(71) Anmelder: **CARL ZEISS-STIFTUNG HANDELND ALS CARL ZEISS**

**W-7920 Heidenheim (Brenz)(DE)**

(84) **GB**

(72) Erfinder: **Benninger, Ralf**
**Junoweg 10**
**W-7082 Oberkochen(DE)**

(54) **Anordnung zur Entstörung eines Schaltnetzteils.**

(57) Anordnung zur Entstörung eines Schaltnetzteils, mit einem Leistungsteil, das ein schaltendes Bauteil (3) enthält und auf einer Platine mit mehreren Leiterebenen (10 - 15, 101, 102) und jeweils dazwischenliegenden Isolierschichten (91 - 95) aufgebaut ist, wobei die beiden Pole ( +, -) des Leistungsteils in übereinanderliegenden ersten (10 - 12) und zweiten (13) Leiterbahnen geführt werden und mit dem Eingang (10) des schaltenden Bauteils (3) zwei ober- und unterhalb davon liegenden dritte und vierte Leiterebenen (101, 102) mit flächigen Leitern verbunden sind, und zwei ober- und unterhalb davon liegende fünfte und sechste Leiterebenen (14, 15) mit flächigen Leitern mit Gerätemasse (16) verbunden sind. Verwendung zur Stromversorgung der Bogenlampen eines Festkörperlasers.

EP 0 495 470 A2

Die Erfindung betrifft eine Anordnung zur Entstörung eines Schaltnetzteils gemäß dem Oberbegriff des Hauptanspruches 1 und deren Verwendung.

Schaltnetzteile sind aufgrund der schnell abfolgenden schnellen Schaltvorgänge hoher Ströme zwangsläufig starke elektromagnetische Störquellen, die stets Entstörmaßnahmen erfordern. Mehrschichtplatinen werden dabei bekannterweise für Schirmzwecke und zum kompakten Aufbau, der ebenfalls für eine Störminderung sorgt, benutzt.

Die Problematik ist z.B. aus DE 2 937 539 C 2, entsprechend US 4 320 307, bekannt, dort jedoch für eine Schaltung mit galvanisch getrennten Teilen speziell beschrieben.

Die Entstörung von Schaltnetzteilen für Bogenlampen von Festkörperlasern ist besonders problematisch wegen der hohen Spannungen und Ströme, die mit sehr kurzen Schaltzeiten und hoher Schaltfrequenz zu schalten sind.

Aufgabe der Erfindung ist die Schaffung einer gattungsgemäßen Anordnung mit sehr hoher Entstörwirkung und wenigen elektronischen Bauteilen, also sparsamem Aufbau. Diese soll insbesondere den Anforderungen bei einem Netzteil für Festkörperlaser unter Einhaltung entsprechender Normen entsprechen.

Gelöst wird die Aufgabe durch Einführung der kennzeichnenden Merkmale des Anspruchs 1.

Demnach werden die beiden Pole des Leistungsteils des Schaltnetzteils in zwei übereinanderliegenden Leiterebenen einer Mehrschicht-Platine geführt und eine doppelte Abschirmung vorgesehen, bei der zwei Leiterebenen ober- und unterhalb mit einem Pol des Eingangskreises des Schaltnetzteils verbunden sind und zwei weitere, diese oben und unten umgebende Leiterebenen mit der Gerätemasse verbunden sind.

Die Unteransprüche 2 und 3 betreffen vorteilhafte Ausführungsformen, Anspruch 4 die bevorzugte Verwendung als Laser-Netzgerät.

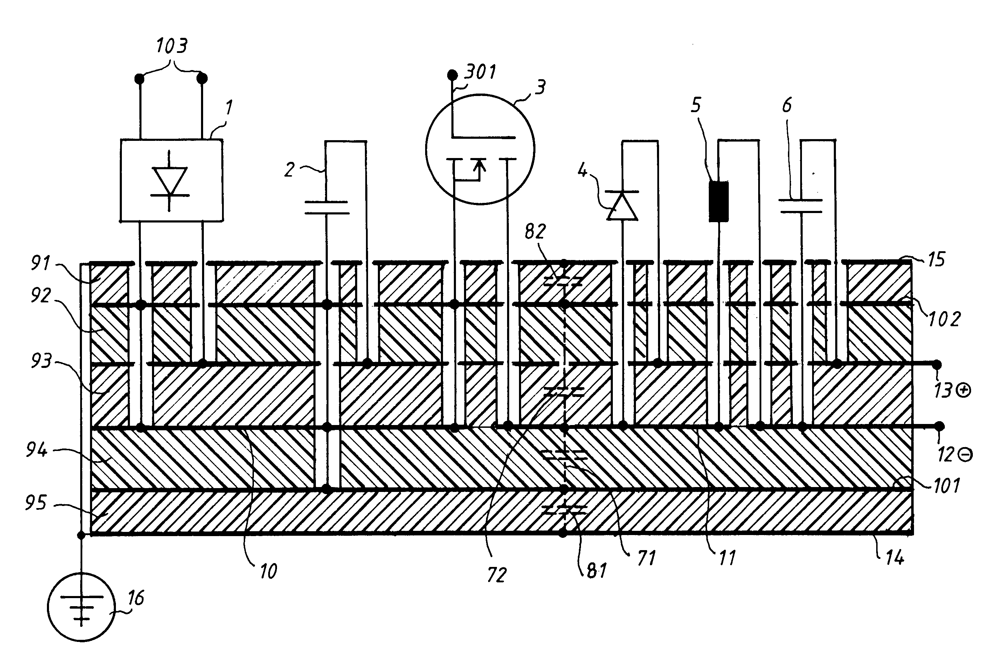

Näher erläutert wird die Erfindung mit Hilfe der Zeichnung Figur 1, die einen schematischen Schnitt durch die Anordnung darstellt.

Ein Gleichrichter (1), ein Ladekondensator (2), ein Schalttransistor (3), eine Freilaufdiode (4), eine Glättungsdrossel (5) und ein Glättungskondensator (6) sind in bekannter Weise als Leistungsteil eines Schaltnetzteils verschaltet. Der Gleichrichter (1) wird über Anschlüsse (103) mit Spannung, z.B. Netzspannung, versorgt. Das Gate des Transistors (3) wird über einen Anschluß (301) und eine bekannte Steuerschaltung, die hier nicht näher beschrieben wird, angesteuert.

In einer ersten Leiterebene der Platine liegen die Leiterbahnen (10, 11 und 12). Getrennt durch eine Isolierschicht (93) liegt eine zweite Leiterebene (13).

Die Leiterbahn (10) verbindet den Minuspol (-) des Gleichrichters (1) und des Ladekondensators (2) mit Source des Transistors (3) und bildet so dessen Eingang.

Drain des Transistors (3), Freilaufdiode (4) und Glättungsdrossel (5) sind durch die Leiterbahn (11) zum Zwischenkreis verbunden. Der zweite Anschluß der Glättungsdrossel (5) und der Glättungskondensator (6) bilden mit der dritten Leiterbahn (12) in dieser ersten Leiterebene den Ausgangskreis.

Die geschalteten Potentiale von Zwischen- und Ausgangskreis liegen also in dieser ersten Leiterebene.

In der zweiten Leiterebene (13) ist der Pluspol des Gleichrichters (1) mit dem Ladekondensator (2), der Freilaufdiode (4), dem Glättungskondensator (6) und dem Ausgang verbunden.

Das geschaltete und das ruhende Potential liegen also übereinander. Die Kommutierungsinduktivität erzeugt dadurch nur kleine Überspannungen an den Bauteilen (1) bis (6) und das elektromagnetische Feld ist gegenüber einem Aufbau in nur einer Leiterebene reduziert. Zunächst bildet dieser Aufbau aber durch die flächige Leiterverlegung einen parasitären Kondensator zu geerdeten Gehäuseteilen, so daß ein unsymmetrischer Störstrom fließen würde. Konventionelle Zusatzbeschaltungen zur Begrenzung und Kompensation sind aufwendig und voluminös.

Durch die erfindungsgemäß vorgesehenen dritten und vierten Leiterebenen (101, 102) mit flächigen Leitern, welche durch Isolierschichten (92, 94) von den oben genannten Leiterebenen (10 bis 13) getrennt und mit der Leiterbahn (10), also dem Eingang des Transistors (3), durch Anschlußdrähte von Gleichrichter (1) und/oder Ladekondensator (2) und/oder Transistor (3) verbunden sind, wird dies unterdrückt.

Unabhängig davon, welcher Pol des Gleichrichters (1) durch den Transistor (3) geschaltet wird, und welcher Pol an Masse liegt, werden die dritte und vierte Leiterebene (101, 102) stets mit dem vom Transistor (3) geschalteten Pol verbunden.

Der getaktete Teil, insbesondere Leiterbahn (11), hat nun durch die Streukapazitäten (71, 72) (gestrichelt gezeichnet) eine definierte Kapazität zum ruhenden Teil, also Leiterbahn (10) und Leiterebenen (101, 102), so daß der Störstrom größtenteils darüber abfließt.

Die für die hohen Frequenzen des Störstroms erforderliche Niederinduktivität wird durch die beidseitige Anordnung der als Kondensatorplatten wirkenden Leiterebenen (101, 102) realisiert.

Eine weitere Dämpfung der Störungen wird durch die zusätzliche Abschirmung an Gerätemasse (16) erreicht. Mit Isolierschichten (91, 95) sind dazu weitere zwei, fünfte und sechste Leiterebenen (14, 15) mit flächigen Leitern angebracht und leitend mit der Gerätemasse (16) vorzugsweise an nur einer Stelle verbunden. Die restlichen Streukapazitäten (81, 82) (gestrichelt gezeichnet) werden damit an die jeweils gegenüberliegenden Leiterebenen (101, 14) bzw. (102, 15) gebunden. Es wird damit die Funktion eines Y-Kondensators erreicht. Die Leiterebenen (14, 15) werden, was nicht in der Zeichnung dargestellt ist, in der Regel mit weiteren Isolierschichten nach außen belegt als mechanischer Schutz und zur Verhinderung von Erdschleifen oder Kurzschlüssen bei Berührung mit anderen Schaltungsteilen.

Ein ausgeführtes Schaltnetzteil für Bogenlampen von Festkörperlasern mit einem Ausgangsstrom von 30 A bei 400 V, 30 KHz Takt und einer Schaltzeit von etwa 100 ns, erreicht bei einer Störspannungsmessung entsprechend VDE 0871 eine Dämpfung von 20 bis 30 dB μV im Bereich von Störfrequenzen oberhalb 150 KHz.

Die elektronischen Bauelemente (1) bis (6) können ein- oder beidseitig auf der Platine angebracht werden, wobei die Anschlüsse möglichst kurz zu halten sind.

Die erforderlichen Verbindungen, insbesondere von der Leiterbahn (10) zu den Leiterebenen (101, 102) können mittels der Anschlüsse der Bauelemente (1) bis (6) oder mittels separaten Durchkontaktierungen einfach oder mehrfach über die Fläche verteilt erfolgen.

Abwandlungen der eigentlichen Schaltnetzteilschaltung aus den Bauelementen (1) bis (6), z.B. Verwendung eines Thyristors als schaltendes Bauteil statt des Transistors (3) und dergleichen sind möglich.

Weitere Störschutzmaßnahmen, z.B. an Zu- und Ableitungen oder am Gehäuse, werden durch die erfindungsgemäße Ausführung nicht berührt und sind voll kombinierbar.

**Patentansprüche**

1. Anordnung zur Entstörung eines Schaltnetzteils, mit einem Leistungsteil, das ein schaltendes Bauteil enthält und auf einer Platine mit mehreren Leiterebenen (10-15, 101, 102) und jeweils dazwischenliegenden Isolierschichten (91-95) aufgebaut ist, dadurch gekennzeichnet, daß die beiden Pole (+, -) des Leistungsteils in übereinanderliegenden ersten (10-12) und zweiten (13) Leiterbahnen geführt werden und daß mit dem Eingang (10) des schaltenden Bauteils (3) zwei ober- und unterhalb davon liegenden dritte und vierte Leiterebenen (101, 102) mit flächigen Leitern verbunden sind, und daß zwei Ober- und unterhalb davon liegende fünfte und sechste Leiterebenen (14, 15) mit flächigen Leitern mit Gerätemasse (16) verbunden sind.

2. Anordnung nach Anspruch 1, dadurch gekennzeichnet, daß auf der Platine ein Gleichrichter (1), ein Ladekondensator (2), ein Schalttransistor (3), eine Freilaufdiode (4), eine Glättungsdrossel (5) und ein Glättungskondensator (6) als Leistungsteil verschaltet sind.

3. Anordnung nach Anspruch 1 oder 2, dadurch gekennzeichnet, daß die dritte und vierte Leiterebene (101, 102) mittels der Anschlüsse von Bauteilen (1, 2, 3) mit dem Eingang (10) des schaltenden Bauteils (3) verbunden sind.

4. Verwendung eines Schaltnetzteils nach mindestens einem der Ansprüche 1 bis 3 zur Stromversorgung der Bogenlampen eines Festkörperlasers.